# EUROPÄISCHE PATENTSCHRIFT

(11) **EP 0 638 928 B1**
(45) Veröffentlichungstag und Bekanntmachung des Hinweises auf die Patenterteilung: **14.10.1998**
(21) Anmeldenummer: 94111249.2
(22) Anmeldetag: 19.07.1994
(51) Int. Cl.: H01L 23/48, H01L 23/051, H01L 23/492

(54) **Leistungs-Halbleiterbauelement mit Druckkontakt**
Power semiconductor device with pressure contact
Dispositif à semi-conducteur de puissance ayant des contacts à pression

(30) Priorität: 09.08.1993 DE 4326733
(43) Veröffentlichungstag der Anmeldung: 15.02.1995
(73) Patentinhaber: SIEMENS AKTIENGESELLSCHAFT, 80333 München (DE)
(72) Erfinder: Kuhnert, Reinhold, Dr.,Dipl.-Phys., D-80637 München (DE)

(56) Entgegenhaltungen:
- EP-A- 0 285 074
- DE-A- 2 023 436
- DE-A- 3 838 968
- US-A- 4 403 242
- PATENT ABSTRACTS OF JAPAN vol. 6, no. 155 (E-125) 17. August 1982 & JP-A-57 078 144 (HITACHI LTD.) 15. Mai 1982
- SURFACE AND COATINGS TECHNOLOGY, Bd.49, 1991, LAUSANNE, CH Seiten 543 - 547 H. DIMIGEN ET AL
- PATENT ABSTRACTS OF JAPAN vol. 10, no. 95 (E-395) 12. April 1986 & JP-A-60 239 044 (SUMITOMO) 27. November 1985
- PATENT ABSTRACTS OF JAPAN vol. 8, no. 103 (E-244) 15. Mai 1984 & JP-A-59 021 033 (MITSUBISHI) 2. Februar 1984

## Beschreibung

Die Erfindung bezieht sich auf ein Leistungs-Halbleiterbauelement mit einem Halbleiterkörper, mit einer anodenseitigen und einer katodenseitigen Kontaktelektrode aus einem Metall, dessen thermischer Ausdehnungskoeffizient von dem des Halbleiterkörpers abweicht, und mit mindestens zwei unter Druck stehenden aufeinanderliegenden Kontaktflachen zwischen dem Halbleiterkörper und den Kontaktelektroden.

Solche Leistungs-Halbleiterbauelemente sind Stand der Technik (man vgl. z.B. die DE-AS 1 185 728).

Bei Leistungs-Halbleiterbauelementen der oben angegebenen Art tritt das Problem auf, daß sich die unter Druck aufeinanderliegenden Kontaktflachen wegen ihrer unterschiedlichen thermischen Ausdehnungskoeffizienten bei Lastwechseln relativ zueinander bewegen. Dies kann zum Verschweißen der Kontaktflächen durch Reibung führen. Es hat daher in der Vergangenheit nicht an Versuchen gefehlt, geeignete Materialpaarungen für die Kontaktflachen auszusuchen, bei denen ein Verschweißen nicht auftritt.

Der Erfindung liegt die Aufgabe zugrunde, ein Leistungs-Halbleiterbauelement der angegeben Art derart weiterzubilden, daß die Reibung der Kontaktflächen gegenüber bekannten Paarungen vermindert wird.

Dies wird dadurch erreicht, daß mindestens eine der Kontaktflächen mit einer Schicht versehen ist, die aus einer amorphen Kohlenstoff-Metallverbindung besteht.

Weiterbildungen der Erfindung sind Gegenstand der Unteransprüche.

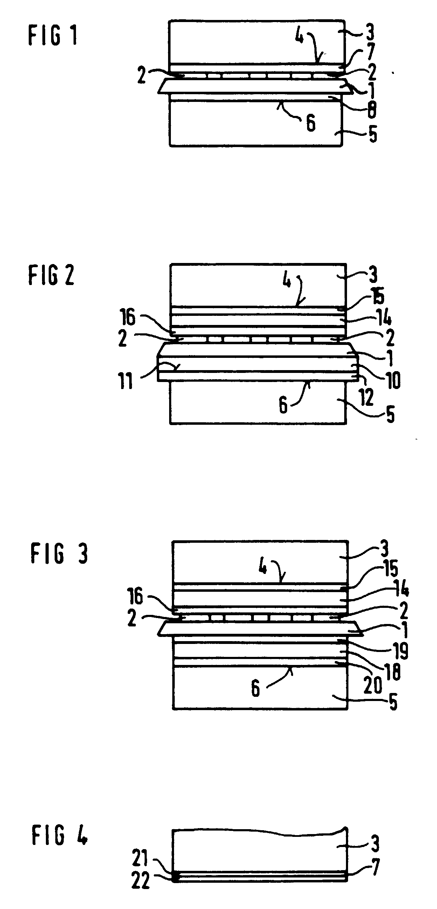

Die Erfindung wird anhand von vier Ausführungsbeispielen in Verbindung mit den Figuren 1 bis 4 näher erläutert. Die Figuren zeigen jeweils die Seitenansicht auf ein ungekapseltes Leistungs-Halbleiterbauelement.

Die Anordnung nach Figur 1 hat einen Halbleiterkörper 1 mit Katodenkontakten 2. An den Halbleiterkörper ist katodenseitig eine Kontaktelektrode 3 angedrückt, an die Anodenseite eine Kontaktelektrode 5. Die dem Halbleiterkörper 1 zugewandten Kontaktflachen beider Kontaktelektroden sind mit 4 bzw. 6 bezeichnet.

Die Kontaktelektroden bestehen üblicherweise aus Kupfer, der Halbleiterkörper aus Silizium. Kupfer und Silizium haben stark voneinander abweichende thermische Ausdehnungskoeffizienten. Um die Reibung zwischen den Kontaktelektroden 3, 5 einerseits und dem Halbleiterkörper andererseits gering zu halten, sind die Kontaktflächen 4, 6 mit je einer Schicht 7, 8 versehen, die aus einer amorphen Kohlenstoff-Metallverbindung besteht. Diese Kohlenstoff-Metallverbindung kann z.B. eine Kohlenstoff-Wolframverbindung oder eine Kohlenstoff-Molybdänverbindung sein. Eine solche amorphe Schicht erhält man, indem die Verbindung z. B. durch Sputtern eines Metall- oder Metallcarbid-Targets in einer Argon-Kohlenwasserstoffatmosphäre abgeschieden wird. Dies kann in einem Hochfrequenz- oder Gleichspannungsfeld geschehen. Solche Verfahren sind an sich bekannt und werden hier daher nicht besonders erläutert. (Man vergleiche z.B. den Artikel von Dimigen und Klages "Microstructure and wear behavior of metal-containing diamond-like coatings" in Surface and Coatings Technology, 49(1991), S. 543-547.) Für den erwähnten Zweck hat sich eine Dicke zwischen 0,5 und 10 µm als ausreichend erwiesen.

Bei den genannten Materialien besteht ein Zusammenhang zwischen spezifischem Widerstand und dem Reibungskoeffizienten der abgeschiedenen Schichten. Dieser Zusammenhang ist ebenfalls aus der obengenannten Literatur bekannt. Mit zunehmendem Metall/Kohlenstoffverhältnis nimmt der Schichtwiderstand ab und der Gleitreibungskoeffizient zu. Das Herstellverfahren erlaubt eine Einstellung dieser Größen. Für die Herstellung einer die elektrischen Eigenschaften des Bauelements unbeeinflußt lassende Gleitschicht empfiehlt sich im Falle des Systems Wolfram/Kohlenstoff ein Atomverhältnis zwischen 0,1 und 0,2. Kann ein bestimmter Widerstand zugelassen werden, ist der Übergang zu kleineren W/C-Werten (<0,05 z.B. 0,02) unkritisch, da der Reibungskoeffizient dadurch weiter verringert wird.

Es ist auch möglich, die Schichten auf Kontaktelektroden aufzubringen, die aus einem anderen Metall als Kupfer bestehen, z.B. aus Aluminium oder Silber.

Das Ausführungsbeispiel nach Figur 2 unterscheidet sich von dem nach Figur 1 im wesentlichen dadurch, daß zwischen den Kontaktelektroden 3, 5 und dem Halbleiterkörper 1 Scheiben 10, 14 angeordnet sind, deren thermischer Ausdehnungskoeffizient zwischen dem des Silizium des Halbleiterkörpers und dem des Kupfers der Kontaktelektroden liegt. Die Scheiben 10, 14 können in bekannter Weise aus Wolfram oder Molybdän bestehen. Die Scheibe 14 ist auf ihrer der Kontaktfläche 4 der Kontaktelektrode 3 zugewandten Seite mit einer Schicht 15 und auf ihrer dem Halbleiterkörper 1 zugewandten Seite mit einer Schicht 16 versehen. Beide Schichten bestehen aus der amorphen Kohlenstoff-Metallverbindung. Die Scheibe 14 liegt über die Schichten 15, 16 lediglich unter Druck an der Kontaktelektrode 3 bzw. am Halbleiterkörper 1 an. Anodenseitig ist der Halbleiterkörper stoffschlüssig, z.B. durch Legieren oder Niedertemperaturverbindung, mit einer Scheibe 10 verbunden, deren thermischer Ausdehnungskoeffizient zwischen dem des Siliziums des Halbleiterkörpers und dem des Kupfers der Kontaktelektrode 5 liegt. Die Scheibe 10 hat eine der Kontaktelektrode 5 zugewandte Kontaktfläche 11, die mit einer Schicht 12 versehen ist. Auch die Schicht 12 besteht aus der amorphen Kohlenstoff-Metallverbindung. Die anodenseitige Kontaktelektrode 5 liegt mit ihrer dem Halbleiterkörper zugewandten Kontaktflache 6 lediglich unter-Druck an der Schicht 12 an, ist mit dieser also nicht stoffschlüssig verbunden.

Bei Lastwechseln kann sich daher die Scheibe 14 unter geringer Reibung lateral sowohl relativ zur Kontaktelektrode 3 als auch zum Halbleiterkörper 1 bewegen. Ebenso kann sich die Kontaktelektrode 5 lateral relativ zur Scheibe 10 und zum Halbleiterkörper 1 bewegen.

Das Ausführungsbeispiel nach Figur 3 unterscheidet sich von dem nach Figur 2 im wesentlichen dadurch, daß zwischen dem Halbleiterkörper 1 und der anodenseitigen Kontaktelektrode 5 eine Molybdän- oder Wolframscheibe 18 liegt, die beidseitig mit Schichten 19, 20 aus der amorphen Kohlenstoff-Metallverbindung versehen ist. Dabei liegt die Scheibe 18 über die Schichten 19, 20 lediglich unter Druck am Halbleiterkörper 1 bzw. an der Kontaktelektrode 5 an. Hier ist ein reibungsarmes laterales Gleiten der Scheibe 18 sowohl gegen den Halbleiterkörper 1 als auch gegen die Kontaktelektrode 5 möglich.

Das Atomverhältnis von Metall zu Kohlenstoff muß nicht über die Dicke der Schicht konstant sein. Es kann auf der Oberseite von dem auf der Unterseite abweichen. Im Ausführungsbeispiel nach Figur 4 hat die an der Kontaktelektrode 3 anliegende Teilschicht 21 ein höheres Atomverhältnis von Metall zu Kohlenstoff als die für den gleitenden Druckkontakt vorgesehene Teilschicht 22. Erstere hat somit einen niedrigen Widerstand, letztere einen niedrigen Reibungskoeffizienten. Die Schicht 21 hat vorzugsweise eine größere Dicke als die Schicht 22. Damit läßt sich ein niedriger Kontaktwiderstand mit guten Gleiteigenschaften kombinieren.

## Patentansprüche

1. Leistungs-Halbleiterbauelement mit einem Halbleiterkörper (1), mit einer anodenseitigen und einer katodenseitigen Kontaktelektrode (5,3) aus einem Metall, dessen thermischer Ausdehnungskoeffizient von dem des Halbleiterkörpers abweicht und mit mindestens zwei unter Druck stehenden, aufeinanderliegenden Kontaktflächen (4, 6) zwischen dem Halbleiterkörper und den Kontaktelektroden,
**dadurch gekennzeichnet,** daß mindestens eine der Kontaktflächen (4, 6) mit einer Schicht (7, 8) versehen ist, die aus einer amorphen Kohlenstoff-Metallverbindung besteht.

2. Leistungs-Halbleiterbauelement nach Anspruch 1,
**dadurch gekennzeichnet,** daß die Schicht (7, 8) auf der dem Halbleiterkörper (1) zugewandten Kontaktfläche (4, 6) der Kontaktelektroden (3, 5) angeordnet ist.

3. Leistungs-Halbleiterbauelement nach Anspruch 1 oder 2,
**dadurch gekennzeichnet,** daß zwischen mindestens einer der Kontaktelektroden (3, 5) und dem Halbleiterkörper (1) eine Scheibe (10, 14; 14, 18) aus einem Metall angeordnet ist, dessen thermischer Ausdehnungskoeffizient zwischen dem der Kontaktelektroden und dem des Halbleiterkörpers liegt, und daß die Scheibe auf beiden Kontaktflächen mit der Schicht (15, 16; 19, 20) versehen ist.

4. Leistungs-Halbleiterbauelement nach Anspruch 1 oder 2,
**dadurch gekennzeichnet,** daß mit dem Halbleiterkörper (1) anodenseitig eine Scheibe (10) stoffschlüssig verbunden ist, die aus einem Metall besteht, dessen thermischer Ausdehnungskoeffizient zwischen dem des Halbleiterkörpers und dem der anodenseitigen Kontaktelektrode (5) liegt und daß die der Kontaktelektrode (5) zugewandte Kontaktfläche (11) der Scheibe mit der Schicht (12) versehen ist.

5. Leistungs-Halbleiterbauelement nach einem der Ansprüche 1 bis 4,
**dadurch gekennzeichnet,** daß das Metall der Schicht Wolfram ist.

6. Leistungs-Halbleiterbauelement nach einem der Ansprüche 1 bis 4,
**dadurch gekennzeichnet**, daß das Metall der Schicht Molybdän ist.

7. Leistungs-Halbleiterbauelement nach einem der Ansprüche 1 bis 6,
**dadurch gekennzeichnet,** daß das Atomverhältnis von Metall zu Kohlenstoff zwischen 0,02 und 0,2 liegt.

8. Leistungs-Halbleiterbauelement nach Anspruch 7,
**dadurch gekennzeichnet**, daß das Atomverhältnis zwischen 0,1 und 0,2 liegt.

9. Leistungs-Halbleiterbauelement nach einem der Ansprüche 1 bis 8,
**dadurch gekennzeichnet**, daß die Schicht etwa 0,5-10 µm dick ist.

10. Leistungs-Halbleiterbauelement nach einem der Ansprüche 1 bis 9,
**dadurch gekennzeichnet,** daß das Atomverhältnis von Metall zu Kohlenstoff der Schicht (7, 8; 15, 16; 12; 19, 20) auf ihrer Oberseite von dem auf ihrer Unterseite abweicht.

## Claims

1. Power semiconductor device with a semiconductor body (1), with an anode-side and a cathode-side contact electrode (5, 3) made of a metal whose thermal expansion coefficient differs from that of the semiconductor body, and with at least two contact areas (4, 6), which lie on one another and are subjected to pressure, between the semiconductor body and the contact electrodes,
characterized in that at least one of the contact areas (4, 6) is provided with a layer (7, 8) composed of an amorphous carbon-metal compound.

2. Power semiconductor device according to Claim 1,
characterized in that the layer (7, 8) is arranged on that contact area (4, 6) of the contact electrodes (3, 5) which faces the semiconductor body (1).

3. Power semiconductor device according to Claim 1 or 2,
characterized in that a plate (10, 14; 14, 18) is arranged between at least one of the contact electrodes (3, 5) and the semiconductor body (1), which plate is made of a metal whose thermal expansion coefficient lies between that of the contact electrodes and that of the semiconductor body, and in that the plate is provided with the layer (15, 16; 19, 20) on both contact areas.

4. Power semiconductor device according to Claim 1 or 2,
characterized in that a plate (10) is connected by a material joint to the semiconductor body (1) on the anode side, which plate is composed of a metal whose thermal expansion coefficient lies between that of the semiconductor body and that of the anode-side contact electrode (5), and in that contact area (11) of the plate which faces the contact electrode (5) is provided with the layer (12).

5. Power semiconductor device according to one of Claims 1 to 4,
characterized in that the metal of the layer is tungsten.

6. Power semiconductor device according to one of Claims 1 to 4,
characterized in that the metal of the layer is molybdenum.

7. Power semiconductor device according to one of Claims 1 to 6,
characterized in that the atomic ratio of metal to carbon lies between 0.02 and 0.2.

8. Power semiconductor device according to Claim 7,
characterized in that the atomic ratio lies between 0.1 and 0.2.

9. Power semiconductor device according to one of Claims 1 to 8,
characterized in that the layer has a thickness of about 0.5-10 µm.

10. Power semiconductor device according to one of Claims 1 to 9,
characterized in that the atomic ratio of metal to carbon of the layer (7, 8; 15, 16; 12; 19, 20) differs on the upper side of the said layer from that on the lower side of the said layer.

## Revendications

1. Dispositif à semi-conducteur de puissance, comprenant un corps à semi-conducteur (1), comportant côté anode et coté cathode une électrode de contact (5, 3) composée d'un métal dont le coefficient de dilatation thermique est différent de celui du corps à semi-conducteur, et comprenant entre le corps à semi-conducteur et les électrodes de contact au moins deux surfaces de contact (4, 6) placées l'une au-dessus de l'autre et mises sous pression, caractérisé en ce qu'au moins une des surfaces de contact (4, 6) est pourvue d'une couche (7, 8), laquelle est constituée par un composé amorphe de métal et de carbone.

2. Dispositif à semi-conducteur de puissance selon la revendication 1, caractérisé en ce que la couche (7, 8) est disposée sur la surface de contact (4, 6) orientée vers le corps à semi-conducteur (1) des électrodes de contact (3, 5).

3. Dispositif à semi-conducteur de puissance selon la revendication 1 ou 2, caractérisé en ce qu'entre au moins une des électrodes de contact (3, 5) et le corps à semi-conducteur (1) est disposée une plaquette (10, 14 ; 14, 18) composée d'un métal dont le coefficient de dilatation thermique se situe entre celui des électrodes de contact et celui du corps à semi-conducteur, et en ce que la plaquette est pourvue sur les deux surfaces de contact de la couche (15, 16 ;19, 20).

4. Dispositif à semi-conducteur de puissance selon la revendication 1 ou 2, caractérisé en ce que côté anode une plaquette (10) est reliée intimement au corps à semi-conducteur (1), qui est composée d'un métal dont le coefficient de dilatation thermique se situe entre celui du corps à semi-conducteur et celui de l'électrode de contact (5) côté anode, et en ce que la surface de contact (11) de la plaquette orientée vers l'électrode de contact (5) est pourvue de la couche (12).

5. Dispositif à semi-conducteur de puissance selon l'une des revendications 1 à 4, caractérisé en ce que le métal de la couche est du tungstène.

6. Dispositif à semi-conducteur de puissance selon l'une des revendications 1 à 4, caractérisé en ce que le métal de la couche est du molybdène.

7. Dispositif à semi-conducteur de puissance selon l'une des revendications 1 à 6, caractérisé en ce que le rapport atomique métal/carbone est compris entre 0,02 et 0,2.

8. Dispositif à semi-conducteur de puissance selon la revendication 7, caractérisé en ce que le rapport atomique est compris entre 0,1 et 0,2.

9. Dispositif à semi-conducteur de puissance selon l'une des revendications 1 à 8, caractérisé en ce que l'épaisseur de la couche est de l'ordre de 0,5 à 10 µm.

10. Dispositif à semi-conducteur de puissance selon l'une des revendications 1 à 9, caractérisé en ce que le rapport atomique métal/carbone de la couche (7, 8 ; 15, 16 ; 12 ; 19, 20) sur sa face supérieure est différent de celui sur sa face inférieure.
